# EUROPEAN PATENT APPLICATION

(11) **EP 1 901 025 A2**
(43) Date of publication of application: **19.03.2008**
(21) Application number: 07114225.1
(22) Date of filing: 13.08.2007
(51) Int. Cl.: F41H 13/00, F41B 9/00

(54) **Electric dissuader**

(30) Priority: 23.08.2006 IT MI20061640
(71) Applicant: Oto Melara S.p.A., 19136 La Spezia (IT)
(72) Inventor: Novelli, Flavio, 34077 Ronchi Dei Legionari (Gorizia) (IT)
(74) Representative: De Gregori, Antonella

(57) **Abstract**

Electric dissuader comprising a support unit (2) to generate pressurised liquid and an electric discharge, and a lance unit (3) used to provide at least one jet of said pressurised liquid, to be directed towards a potential target. An electric potential is applied to said jet by means of an electric circuit.

## Description

The present invention relates to an electric dissuader. In particular, the present invention relates to an electric dissuader conceived to send a low voltage electrical discharge in the direction of the selected target. Contact dissuaders are commonly known composed of lances or elongated objects, in any case, objects that can be held in the hand, on the end of which are a pair of electrodes which close an electric circuit when in contact with the predetermined target, sending an electric discharge through the target.

Generally electrostatic dissuaders are based on very rapid high voltage, low current electric impulses operating at 12 Volt direct current. To obtain the necessary high voltage required, an oscillator circuit is applied which, recharges a condenser by means of a step-up transformer. Every 3 - 5 seconds, the condenser is connected to the outlet electrodes for a few µsec; in this way, any type of conducting body that makes contact with the electrodes receives a short electric impulse. The conductor electrodes are composed of two steel strips assembled on insulating supports through which the current is sent.

These commonly known electric dissuaders operate exclusively through direct contact with the target. This can sometimes create limitations in that it can result difficult and even dangerous to be forced to approach the target in order to activate the device.

The Applicant has addressed the problem of providing an electric dissuader device from which the electric discharge can be sent while remaining at a safe distance from the target.

With this aim in mind, the Applicant has discovered that an adequate means for transmitting the electric discharge towards a target while permitting the user to remain at a safe distance, is by means of a water stream sent by the dissuader device towards the target.

One aspect of the present invention relates to an electric dissuader characterised in that it comprises a support unit used to generate pressurised liquid and an electric discharge, as well as a lance device to provide at last one jet of such pressurised liquid to be directed at a potential target, and to apply an electric potential to the liquid jet in such a manner that when the jet attains the target the electric circuit closes to generate an electric discharge on the target.

Further aims and advantages of the present invention will be made more apparent from the following description and from the appended drawings, provided simply as a non limiting example, wherein:

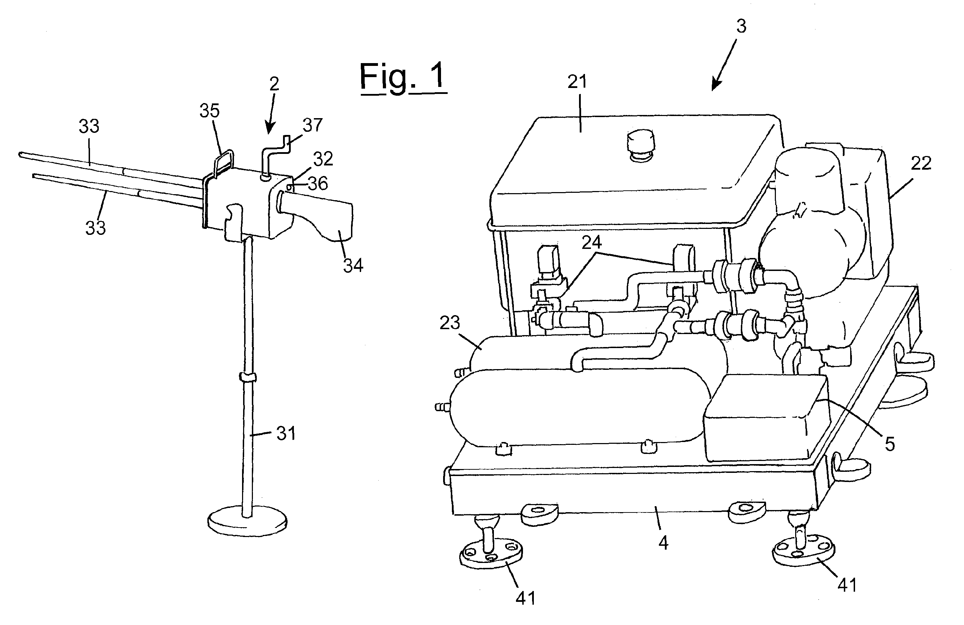

Figure 1 shows a schematic view in perspective of a dissuader device according to an embodiment of the present invention;
Figure 2 shows a schematic view of the electric discharge generator included in the dissuader according to the present invention;
Figure 3 shows the wiring diagram of the dissuader according to the present invention;

In reference to the aforesaid figures, the dissuader according to the invention is shown in a version which can be installed on vehicles, and basically comprising a support unit 2 and a lance unit 3. Said support unit is used to generate pressurised liquid and an electric discharge, while the lance unit is used to provide two jets of such pressurised liquid to be directed at a potential target, and to apply an electric potential difference to said jets, so that when the jets attain the target, the electric circuit closes sending an electric discharge onto the target.

Alternatively, the liquid could be sent in a single jet with an electric potential applied to the jet. In this case the electric circuit would be closed by the connection to earth produced by the target itself combined with earthing created within the dissuader in question.

In one embodiment of the present invention the electric dissuader could be produced in a portable version, in other words, wherein the lance unit could be handled by the operator, and the support unit could be worn by the operator, for example contained in a backpack.

Said lance unit is basically composed of a support base 31, to which it is attached in an articulated manner, by a flexible means such as a universal joint for example, a lance unit comprising a lance tank 32, having preferably a box-like configuration, from which a pair of nozzle barrels 33 extend on one side, and a gunstock 34 protrudes from the other side, to permit the operator an easy grip on the device. Furthermore on the upper surface of the tank is a handle 35 for use together with the gunstock to control the direction movement of the lance device. The nozzle barrels can be conceived with differing angles according to the required firing distance. For example, the nozzle barrels can be basically parallel for firing distances less than 5 metres, whereas they can be positioned at wider angle for longer distances.

For this purpose it is advantageously possible to provide established notches on the gun in order to adjust firing distances. Furthermore it is also possible to provide a device to identify the distance of the target under aim such as ultrasound or Laser sighter.

A switch 36 is also positioned on the tank to activate the electric discharge, as well as a lever 37 to open and close the distribution valve of the liquid which is sent to the barrels through conventional flexible hoses (not shown) from the support base.

Said support base can be advantageously positioned on a plate 4 equipped with support feet 41, and can include a device 5 to generate the electric discharge and a device to supply the liquid under pressure in the lance unit.

Said device for pressurised liquid supply to the lance unit preferably comprises a tank for liquids 21, a gas compressor 22, and a device to activate the liquid jet, such as a pair of gas cylinders 23 for example, in which the liquid is sent under pressure from the tank by means of a pair of electrovalves 24. This device for liquid supply uses the compressor to transfer the liquid contained in the tank under pressure and sent it to the lance unit.

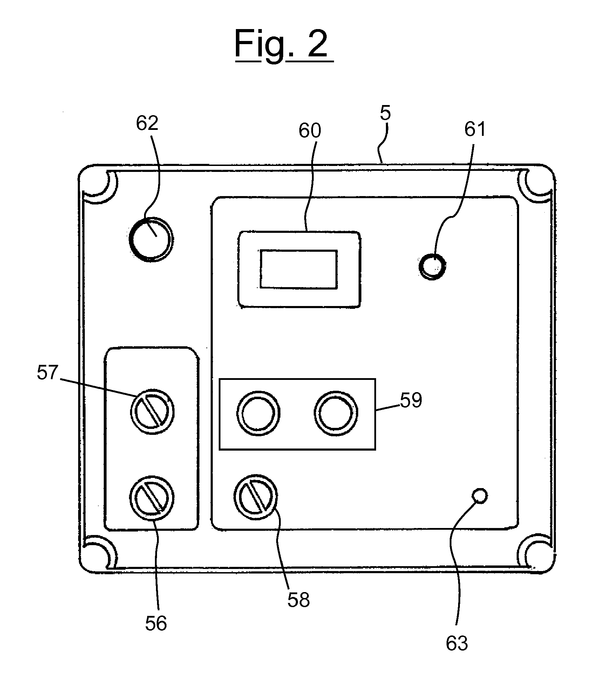

Figure 2 shows the box-like case that contains the circuit for generating the electric discharge. This includes a switch 56 to activate the electrovalve for liquid loading, a switch 57 to activate the high pressure electrovalve, a switch 58 to switch on the generator, an indicator 59 to show the generator is active (such as leds showing ready-active), an indicator 60 showing the voltage in out-put from the circuit, an adjustment dial 61 to regulate the intensity of the discharge, a lamp 62 to show supply voltage presence, and a connection bush 63 for remote control of the total electric discharge device.

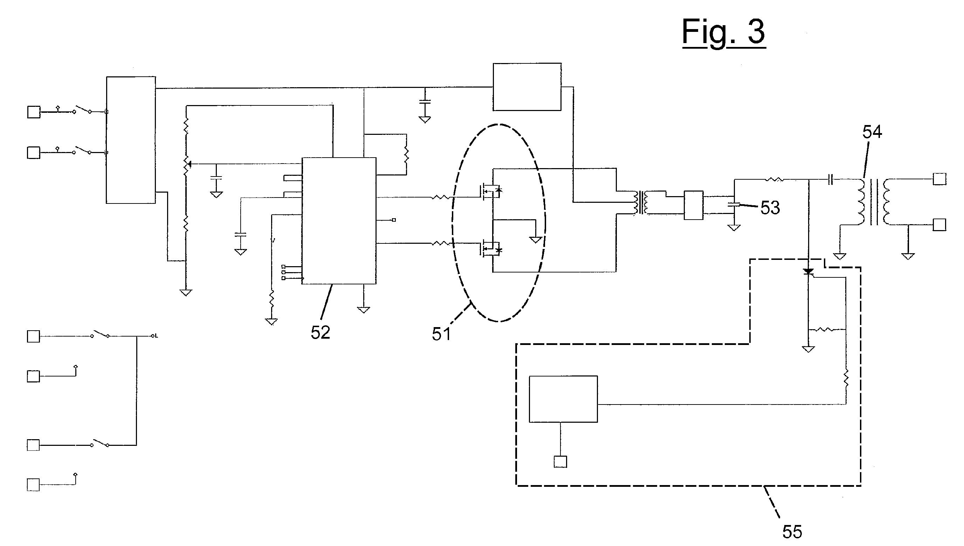

The device for generating the electric discharge 5 is composed of an electronic circuit shown in a nonlimiting example in figure 3. Said circuit is able to generate a variable application voltage such as 50 kVolts or 75 kVolts, for example.

In particular, said circuit comprises a transistor switch 51, appropriately controlled by an integrated circuit 52 that operates the charge of a condenser 53 connected to the primary of a transformer 54 and charged to a preset voltage by means of said switch (initially open). When the condenser is charged and the switch is closed, the current impulse that is proposed to the transformer primary provokes an impulse in a form similar to the secondary, but with a step-up in voltage having a factor equal to the coil ratio of the transformer.

The circuit also comprises a regulating circuit 55 to control the intensity of the electric discharge which uses a conventional TRIAC and an impulse generator, for example.

## Claims

1. Electric dissuader **characterised in that** it comprises a support unit (2) used to generate pressurised liquid and an electric discharge, and a lance unit (3) used to provide at least one jet of said pressurised liquid, to be directed towards a potential target, and to apply to said jet an electric potential in a manner such that when the target is attained by the jet, the electric circuit is closed generating an electric discharge on the target in question.

2. Electric dissuader according to claim 1, wherein the liquid jets are two in number and they are both applied with a potential difference.

3. Electric dissuader according to claim 1, wherein said lance unit comprises a support base (31) to which a lance device is attached in an articulated manner.

4. Electric dissuader according to claim 3, wherein said lance device comprises a lance tank (32), a pair of nozzle barrels (33) and a gunstock (34) conceived to permit easy lance device handling by the operator.

5. Electric dissuader according to claim 4, wherein, on the upper surface of the said tank is a handle (35) for combined use with said gunstock to control the movement of the lance device.

6. Electric dissuader according to claim 4, wherein on said lance tank are a switch (36) to activate the electric discharge, and a lever (37) to open and close the electrovalve for liquid distribution sent to the barrels by means of hoses from the support unit.

7. Electric dissuader according to claim 1, wherein said support unit comprises a device to generate the electric discharge (5) and a device to supply the liquid under pressure to said lance unit.

8. Electric dissuader according to claim 7, wherein said device for liquid supply under pressure to said lance unit comprises a liquid tank (21), a gas compressor (22) and an actuator device for the liquid jet composed of a pair of gas cylinders (23) into which the liquid is fed under pressure from the tank by means of a pair of electrovalves (24).

9. Electric dissuader according to claim 7, wherein the device for electric discharge generation is provided by an electronic circuit comprising a transistor switch (51) appropriately operated by an integrated circuit (52) which controls the charge of a condenser (53) connected to the primary winding of a transformer (54) and charged at a preset voltage by means of said switch that is initially open, and which, when the condenser is charged, the switch closes and the current impulse that is proposed to the transformer primary provokes an impulse having a similar form to the secondary, but with a step-up in voltage having a factor equal to the coil ratio of the transformer in question.

10. Electric dissuader according to claim 9, wherein the circuit also comprises a regulating circuit (55) to adjust the intensity of the electric discharge.

11. Electric dissuader according to claim 1, wherein said lance unit comprises a device to identify the distance of the target to be hit.

12. Electric dissuader according to claim 1, wherein said identification device is an ultrasound or Laser sighter.
